(19) Europäisches Patentamt / European Patent Office / Office européen des brevets

(11) **EP 4 053 532 B1**

(12) **EUROPEAN PATENT SPECIFICATION**

(45) Date of publication and mention
of the grant of the patent:
**03.09.2025   Bulletin 2025/36**

(21) Application number: **20880958.2**

(22) Date of filing: **03.09.2020**

(51) International Patent Classification (IPC):
**G01R 31/34** (2020.01)    **G01M 99/00** (2011.01)
**G01M 13/025** (2019.01)

(52) Cooperative Patent Classification (CPC):
**G01M 99/007; G01M 13/025; G01R 31/343**

(86) International application number:
**PCT/JP2020/033475**

(87) International publication number:
**WO 2021/084906 (06.05.2021 Gazette 2021/18)**

(54) **ROTATING MACHINE DIAGNOSIS SYSTEM**

DIAGNOSESYSTEM FÜR ROTIERENDE MASCHINEN

SYSTÈME DE DIAGNOSTIC DE MACHINE ROTATIVE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:   **31.10.2019   JP 2019198158**

(43) Date of publication of application:
**07.09.2022   Bulletin 2022/36**

(73) Proprietor: HITACHI INDUSTRIAL EQUIPMENT
SYSTEMS CO., LTD.
Chiyoda-ku, Tokyo, 101-0021 (JP)

(72) Inventor: **YOSHIZAKI Akio**
**Tokyo 101-0022 (JP)**

(74) Representative: **MERH-IP Matias Erny Reichl
Hoffmann
Patentanwälte PartG mbB
Paul-Heyse-Straße 29
80336 München (DE)**

(56) References cited:
| | |
|---|---|
| JP-A- 2012 118 010 | JP-A- 2013 119 295 |
| JP-A- 2016 040 546 | JP-B2- H0 310 054 |
| US-A1- 2012 001 580 | US-A1- 2012 161 684 |
| US-A1- 2019 003 928 | US-B2- 9 310 439 |

• DEDA S ET AL: "Induction motor efficiency test methods: A comparison of standards", 2017 INTERNATIONAL CONFERENCE ON THE INDUSTRIAL AND COMMERCIAL USE OF ENERGY (ICUE), CAPE PENINSULA UNIVERSITY OF TECHNOLOGY, 15 August 2017 (2017-08-15), pages 1 - 6, XP033164370, DOI: 10.23919/ ICUE.2017.8067991
• KUECK J D: "Development of a method for estimating motor efficiency and analyzing motor condition", PULP AND PAPER INDUSTRY TECHNICAL CONFERENCE, 1998. CONFERENCE RECORD OF 1998 ANNUAL PORTLAND, ME, USA 21-26 JUNE 1998, NEW YORK, NY, USA,IEEE, US, 21 June 1998 (1998-06-21), pages 67 - 72, XP032134267, ISBN: 978-0-7803-4785-4, DOI: 10.1109/ PAPCON.1998.685505
• AARNIOVUORI LASSI ET AL: "Loss Components and Performance of Modern Induction Motors", 2018 XIII INTERNATIONAL CONFERENCE ON ELECTRICAL MACHINES (ICEM), IEEE, 3 September 2018 (2018-09-03), pages 1253 - 1259, XP033427289, DOI: 10.1109/ ICELMACH.2018.8507189

**Description**

TECHNICAL FIELD

The present invention relates to a rotating machine diagnosis technology.

BACKGROUND ART

Patent Document 1 (JP 2004-124765 A) discloses "including a step of determining a start time of an abnormal state immediately before a monitor rotation machine stops from monitor time-series data of a feature amount of the monitor rotation machine used in a monitor manufacturing process, and statistically analyzing the monitor time-series data to obtain a value at the start time of the abnormal state of the feature amount as a threshold value of abnormality determination, a step of measuring time-series data of a feature amount of a motor current of a rotating machine to be diagnosed during a manufacturing process, a step of creating diagnostic data for evaluation from time-series data whose feature amount fluctuates during a manufacturing process, and a step of determining a time when the evaluation diagnostic data exceeds the threshold value as a life of the rotating machine to be diagnosed" (see summary). Patent Document 2 describes a rotary machine diagnostic device that has a current acquisition unit that acquires current from a sensor, which measures the driving current of a rotary machine driving a machine to be driven; a sampling unit that performs sampling of the acquired driving current; a frequency range conversion unit that converts data concerning the time range subjected to sampling into a frequency range; a sideband detection unit that sets the driving current as a carrier wave in the frequency range, and detects, as a sideband, the spectrum appearing on each side of the carrier wave subjected to amplitude modulation; and an abnormality detection unit that detects whether or not there are abnormalities in the rotary machine and the machine to be driven on the basis of the difference in frequency between the sideband frequency detected by the sideband detection unit and the frequency of the carrier wave.

CITATION LIST

PATENT DOCUMENT

Patent Document 1: JP 2004-124765 A
Patent Document 2: US 2019/003928 A1

SUMMARY OF THE INVENTION

PROBLEMS TO BE SOLVED BY THE INVENTION

When predictive maintenance of an induction motor is performed, it is common to use sound, heat, or vibration as a measurement item necessary for analyzing a running state of the induction motor.
Patent Document 1 describes diagnosis of a life of a dry pump, and in the diagnosis of the life, it is important to determine a threshold value serving as a determination criterion. As for a method of determining the threshold value, it is disclosed that time-series data of a maximum current value of the dry pump needs to be measured until the dry pump is stopped in a film forming step in which a current increase of the dry pump for monitoring is recognized in advance. Further, since the motor current is affected by a power supply fluctuation, it is necessary to remove the influence of the power supply fluctuation, and thus a state of equipment connected to the dry pump for monitoring needs to be specified in advance.
That is, the current, etc. of the rotating machine, which is the dry pump to be measured, needs to be measured in advance, and the current fluctuation needs to be taken into consideration including other devices connected to the rotating machine. That is, while a specific abnormal state measured in advance is diagnosed, a method for diagnosing other abnormalities is not considered.
Therefore, an object of the invention is to provide a rotating machine diagnosis system that specifies a state of a rotating machine using load loss of the rotating machine.

SOLUTIONS TO PROBLEMS

The aforementioned object is solved by the invention according to the independent claim 1. Further preferred developments are described by the dependent claims. An example of a rotating machine diagnosis system of the invention is a rotating machine diagnosis system comprising a rotating machine having a load connected thereto, a detection unit configured to detect a running load characteristic when the rotating machine is running, a storage unit, and a control unit, in which a product load characteristic based on product specifications provided by a manufacturer of the rotating machine is stored in the storage unit beforehand, and the control unit is configured to cause the storage unit to store the running load characteristic detected by the detection unit, to specify load loss other than copper loss using the product load characteristic and the running load characteristic, and to cause a display unit to display information based on a fact that the running load characteristic is a characteristic different from usual when load loss other than the copper loss exceeds a predetermined range.

EFFECTS OF THE INVENTION

According to the invention, it is possible to specify a state of a rotating machine using load loss of the rotating machine. Issues, configurations, and effects other than those described above will be clarified by the following description of the embodiment.

BRIEF DESCRIPTION OF THE DRAWINGS

Fig. 1 is an appearance of a system for diagnosing a rotating machine.
Fig. 2 is a block diagram of the system for diagnosing the rotating machine.
Fig. 3 is a diagram illustrating a flowchart in which the system for diagnosing the rotating machine specifies mechanical loss and floating loss, which are other load loss.
Fig. 4 is a diagram illustrating a user interface in which the system for diagnosing the rotating machine illustrates a state of the rotating machine using load loss.
Fig. 5 is a diagram illustrating a user interface in which the system for diagnosing the rotating machine sets a deviation range.
Fig. 6 is a diagram for describing a method in which the system for diagnosing the rotating machine specifies other load loss (mechanical loss + floating loss) using a relationship between active power, power factor, and efficiency of the catalog characteristics, which are product load factors.
Fig. 7 is a block diagram of a system for diagnosing a rotating machine.
Fig. 8 is a flowchart of a diagnosis method using a frequency of the system for diagnosing the rotating machine.
Fig. 9 is a diagram illustrating a method in which the system for diagnosing the rotating machine specifies a state of the rotating machine using a frequency of an inverter and a unit frequency arrival time.
Fig. 10 is a diagram illustrating an example of a diagnosis method using other load loss of the system for diagnosing the rotating machine.
Fig. 11 is a diagram illustrating an example of a diagnosis method using other load loss of the system for diagnosing the rotating machine.
Fig. 12 is a diagram illustrating a system for diagnosing a plurality of rotating machines.

MODE FOR CARRYING OUT THE INVENTION

Hereinafter, the embodiment and examples will be described with reference to the drawings. In all the drawings for describing the examples, the same components are designated by the same reference symbols, and the repeated description thereof will be omitted. When the same reference symbols are attached in different figures, since the same reference symbols described in the other figures have the same configuration in principle, the description may be omitted. In addition, in order to make the drawing easier to understand, hatching may be added in a plan view.

In diagnosis of a rotating machine, a system that repeatedly processes a specific operation may measure a failure in the same operation or a state serving as a sign or an indication corresponding to the failure, and specify the measured sign or indication to set a threshold value of a parameter that changes with respect to the sign or indication, thereby notifying a user or an administrator of the sign or the indication when the parameter exceeds the threshold value during a next operation. In this way, it is possible to change or replace the rotating machine and or peripheral equipment thereof before the rotating machine fails.

However, in a system in which the rotating machine has a plurality of running states, when a specific sign or indication is determined by a threshold value, there may be a case in which, while the operation is normal in a first mode, a sign or indication of a failure is determined in a second mode. When a threshold value is set, and the threshold value is merely used in a plurality of running modes, there may be a case in which, depending on the running mode, it is considered to be a sign or an indication of an abnormality even though the operation is normal, and correct operation is impossible.

In addition, when the rotating machine or a peripheral part thereof is replaced, depending on the state of the part, it may be considered to be a sign or an indication of an abnormality even though the operation is normal. When determination is performed only based on a threshold value, detection of a correct sign or indication is difficult.

That is, it is necessary to specify a normal state of a plurality of running states and an abnormality or a sign or indication that an abnormality occurs. For example, even though it takes some time for aging until a part becomes familiar after part replacement, when a threshold value is set for the part after aging, an aging time immediately after part replacement is insufficient and a state before becoming familiar is determined to be a sign or an indication of an abnormality in some cases. When the user or administrator is notified of such a state, the threshold value is lowered, and a sign or an indication of a truly detected failure is overlooked.

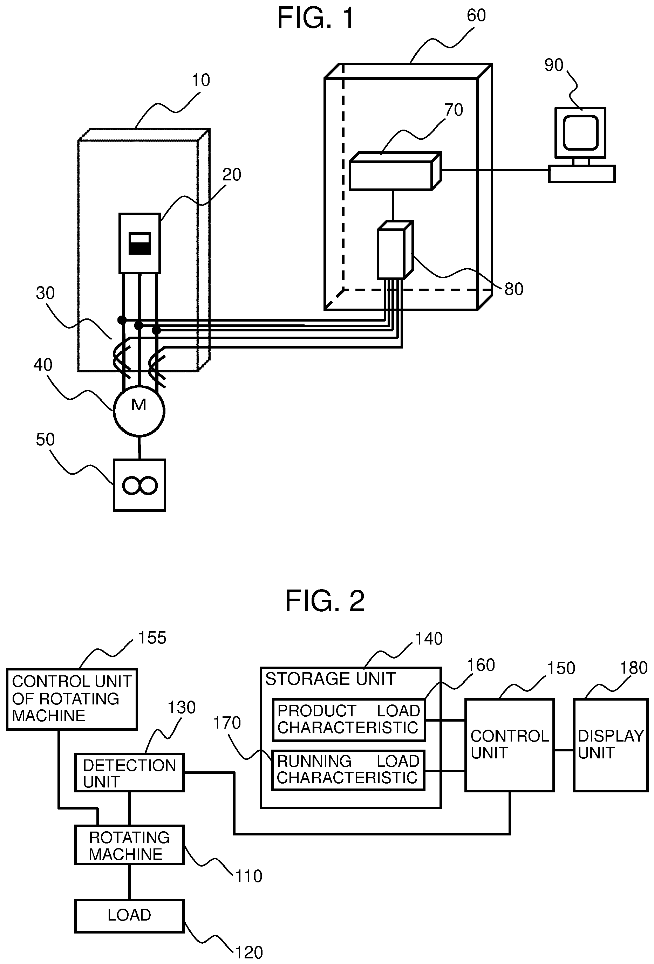

Therefore, the invention provides a system for diagnosing the state of the rotating machine by paying attention to load loss of the rotating machine in consideration of a state of a part connected to the rotating machine and a state of actual operation. Hereinafter, the embodiment will be described with reference to Figs. 1 and 2. Fig. 1 is an appearance of the system for diagnosing the rotating machine. A main configuration of the system for diagnosing the rotating machine according to the present embodiment is that a load 50 such as a fan is connected to an induction motor 40, and a current transformer (CT) 30 detects the current of the induction motor 40. Further, a measuring device 80 measures the current detected by the current transformer (CT) 30 (hereinafter, also simply referred to as CT 30), and the measured current is collected by a data collecting device 70. The system is a system having a central processing unit 90 that controls these devices. The measuring device 80 may measure not only the current detected by the CT 30 but also other information such as a voltage and a frequency of the voltage.

Further, the induction motor 40 generally receives power from a molded case circuit breaker 20 built in a distribution board 10 and drives a load 50 such as a fan based on a control signal of the central processing unit 90, etc.

Here, the symbol of the fan is described as the load of the fan, etc. in this figure. However, for example, the invention may be applied to a load such as a pump portion or a belt conveyor as long as the load can be driven by the induction motor 40.

The measuring device 80 measures various electric quantities based on current and voltage sensing data of a circuit that supplies power from the molded case circuit breaker 20 to the induction motor 40, and in order to sense the current, the current transformer (CT) 30 is built-in and installed in the distribution board 10 to perform current sensing of a circuit to be measured. Note that the current transformer (CT) 30 may be independently installed without being built in the distribution board 10.

Further, with regard to voltage sensing, in this example, the circuit to be measured is directly wired for measurement. However, depending on the voltage, a voltage transformer (VT) may be used. The sensor and the measuring device are not particularly limited as long as sensing can be performed.

The data collecting device 70 collects data of various electric quantities measured by the measuring device 80. A storage unit may be provided to store the collected data. Further, the storage unit may be disposed in the central processing unit 90, and both the data collecting device 70 and the central processing unit 90 may have the storage unit.

The central processing unit 90 has a display unit, etc. that communicates with the data collecting device 70 to display data of various electric quantities or display an abnormality when it is determined that a characteristic different from the usual one described later is determined. The display unit that displays measured data and normal or unusual characteristics may be displayed not only on the central processing unit 90 but also on a tablet terminal, a smartphone, a feature phone, etc. In addition to the graphical display of data, etc., it is possible to display text for the administrator using, for example, e-mail or SMS (Short Message Service). In this example, the measuring device 80 and the data collecting device 70 are built in a control panel 60.

Further, in this example, the data collecting device 70 and the measuring device 80 are separate devices. However, the devices may be integrated. The data collecting device 70 and the central processing unit 90 may communicate with each other not only by wire but also wirelessly, and may communicate with each other partially wirelessly through a gateway, etc.

Further, even though only one CT 30 is illustrated for the sake of brevity, devices such as a plurality of CTs 30 or VTs may be connected to the data collecting device 70. Further, the data collecting device 70 and the CT 30, etc. may be wirelessly or partially wirelessly connected to each other. It is possible to adopt mesh type communication in which a plurality of CTs 30, etc. communicate with each other, and the communication method is not limited.

Fig. 2 is a block diagram of the system for diagnosing the rotating machine. While Fig. 1 has been described with an awareness of physical wiring and appearance, Fig. 2 will be described with reference to a system configuration using the block diagram.

A load 120 driven by the rotating machine 110 is illustrated on the rotating machine 110 such as the induction motor 40. Further, a detection unit 130 that detects a state of the rotating machine 110 for driving the load 120 is included, and a control unit 150 that causes a storage unit 140 to store a state of the rotating machine 110 detected by the detection unit 130 as a running load characteristic 170 is provided.

The storage unit 140 stores a product load characteristic 160 based on product specifications provided by a manufacturer of the rotating machine 110 in advance. The control unit 150 performs predetermined calculation using the running load characteristic 170 and the product load characteristic 160 stored in the storage unit 140, and displays a calculation result on the display unit 180. A calculation method will be described later in each example. When the rotating machine 110 is controlled by an inverter, a control unit 155 of the rotating machine may be added.

In Fig. 2, the control unit 150 causes the storage unit 140 to store a result detected by the detection unit 130 as the running load characteristic 170, performs predetermined calculation using the running load characteristic 170 and the product load characteristic 160, and causes the display unit 180 to display a result thereof. These processes may be provided in different parts. That is, after uploading from the storage unit 140 to a cloud system, a calculation process may be performed and displayed on a display unit of another device or the display unit 180 of this system.

First Example

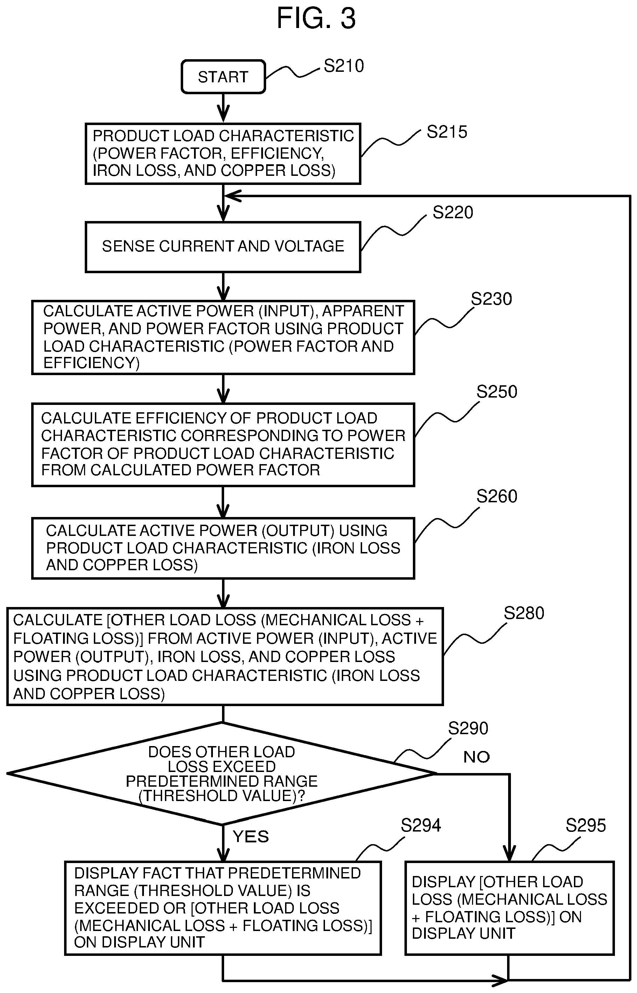

A first example will be described with reference to Figs. 3 to 5. In this specification, the rotating machine will be described as a representative. A DC converter described later includes a power converter and a frequency converter.

Fig. 3 is a diagram illustrating a specific flowchart in which the system for diagnosing the rotating machine specifies mechanical loss + floating loss, which are other load loss. Mechanical loss includes mechanical damage in addition to typical friction loss.

Description will start from step S210, which is a START process of processing of the system for diagnosing the rotating machine of this example.

Step S215 is a process of storing at least the power factor, efficiency, iron loss, and copper loss in the storage unit 140 in the product load characteristic 160 based on the product specifications provided by the manufacturer of the rotating machine in advance. When storing is performed before processing of step S230 and step S280, storing may be performed at any timing. In this flowchart, an example of storing after start of processing is adopted. However, processing of the flowchart of Fig. 3 may be performed even when storing is performed before start of step S210.

In step S220, current and voltage are sensed by the current transformer (CT) 30 connected to a wire (circuit) from the molded case circuit breaker 20 to the induction motor 40. Other parameters such as frequency may be detected. The current transformer (CT) 30 is described as a current transformer (CT) for detecting current and voltage in the device configuration as a representative. However, a device for detecting other parameters may be added. In step S230, active power (input), apparent power, and power factor are calculated from power factor and efficiency information of the stored product load characteristic 160 and sensed current and voltage information.

In step S250, among the active power (input), apparent power, and power factor calculated in step S230 for the power factor and efficiency of the product load characteristic 160, the calculated power factor is assumed to be equivalent to the power factor of the product load characteristic 160, and efficiency of the product load characteristic 160 based on the product specifications provided by the manufacturer in advance is specified.

Here, the product load characteristic 160 based on the product specifications refers to a so-called data sheet provided by the manufacturer of the rotating machine 110. The data sheet describes, as the load characteristics, voltage (V), frequency (Hz), current (A) corresponding to the load factor, efficiency (%), power factor (%), etc. The product load characteristic 160 is also referred to as a catalog load characteristic.

The active power (output) is calculated from the efficiency of the product load characteristic 160 specified in S260. The efficiency may be specified by the following formula.

[Formula 1]

$$\text{Efficiency [\%]} = \frac{\text{Active power (output) [kW]}}{\text{Active power (input) [kW]}} \times 100$$

Therefore, the active power may be specified by the following formula.

[Formula 2]

$$\therefore \text{Active power (output) [kW]} = \frac{\text{Active power (input) [kW]} \times \text{efficiency [\%]}}{100}$$

In step S280, other load loss (mechanical loss + floating loss) is calculated from the calculated active power (input), the specified active power (output), and the product load characteristics (iron loss and copper loss). A value provided by the manufacturer may be used for the iron loss. The iron loss is the sum of hysteresis loss and eddy current loss, is load loss when power is supplied without connecting the load to the rotating machine 110, and may be measured and detected in addition to be provided by the manufacturer. The copper loss is load loss due to winding resistance between terminals and is provided by the manufacturer. The actually measured value may be stored as the product load characteristic in step S215, and the measured value may be used to more accurately diagnose the rotating machine.

In step S290, it is determined that the other load loss (mechanical loss + floating loss) calculated in step S280 exceeds a predetermined range (threshold value), and when the predetermined range is exceeded, the fact that the predetermined range is exceeded or the other load loss (load loss including mechanical loss + floating loss) is displayed on the display unit 180 in step S294. As for the display on the display unit 180, only one of the fact that the predetermined range is exceeded or the other load loss may be displayed. For the determination using the predetermined range, it is possible to use comparison by a flag or a threshold value after addition and subtraction.

Thereafter, the process returns to step S220, and the flow shifts to current sensing and voltage sensing by the current transformer (CT) 30 in the wire (circuit) from the molded case circuit breaker 20 to the induction motor 40, and the same flow transition is continued below.

On the other hand, when the predetermined range (threshold value) is not exceeded, the process proceeds to step S295, and the state of the rotating machine 110 running based on the other load loss (mechanical loss + floating loss) or information about the other load loss is displayed on the display unit 180. Since the rotating machine is operating within the predetermined range, it is possible to perform a process in which the other load loss is not displayed on the display unit 180. A method of specifying the state of the rotating machine 110 based on the information about the other load loss will be described later.

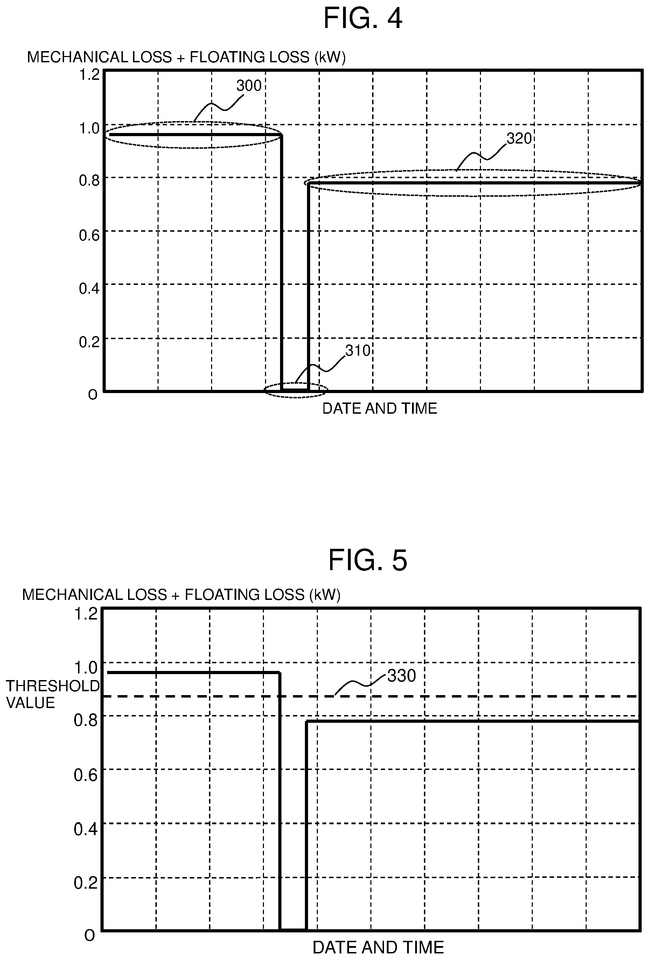

Fig. 4 is a diagram of a user interface in which the system for diagnosing the rotating machine illustrates the state of the rotating machine 110 using the load loss. An example will be given in which the other load loss (mechanical loss + floating loss) is calculated in the block diagram of the system illustrated in Fig. 2 and the system flowchart illustrated in Fig. 3, and the load 120 is a pump.

In Fig. 4, the horizontal axis indicates an elapsed time (running time) of the pump which is the load 120, and the vertical axis plots calculation of other load loss (mechanical loss + floating loss) in the flowchart illustrated in Fig. 3.

In this example, an area 300 plots a normal operation state, an area 310 plots a time zone in which the pump portion, which is the load 120, is being replaced, and an area 320 plots the other load loss (mechanical loss + floating loss) after replacement of the pump portion, which is the load 120. In the replacement time zone, while the pump is being replaced, the rotating machine 110 is not running, and thus mechanical loss + floating loss is zero.

Fig. 4 illustrates that the other load loss (mechanical loss + floating loss) is reduced by replacing the pump portion, which is the load 120.

Fig. 5 is a diagram illustrating a user interface in which the system for diagnosing the rotating machine 110 sets a deviation range. This example is an example of setting the deviation range based on Fig. 4, and is an example of arbitrarily setting and displaying a threshold value 330 and comparing the threshold value 330 with the other load loss (mechanical loss + floating loss), which is a calculation result.

In this way, a difference between the threshold value and other current load loss (mechanical loss + floating loss) may be sequentially determined at a glance, and when the threshold value is exceeded, the exceeding value may be recognized as an unusual value, and the rotating machine 110 may be diagnosed.

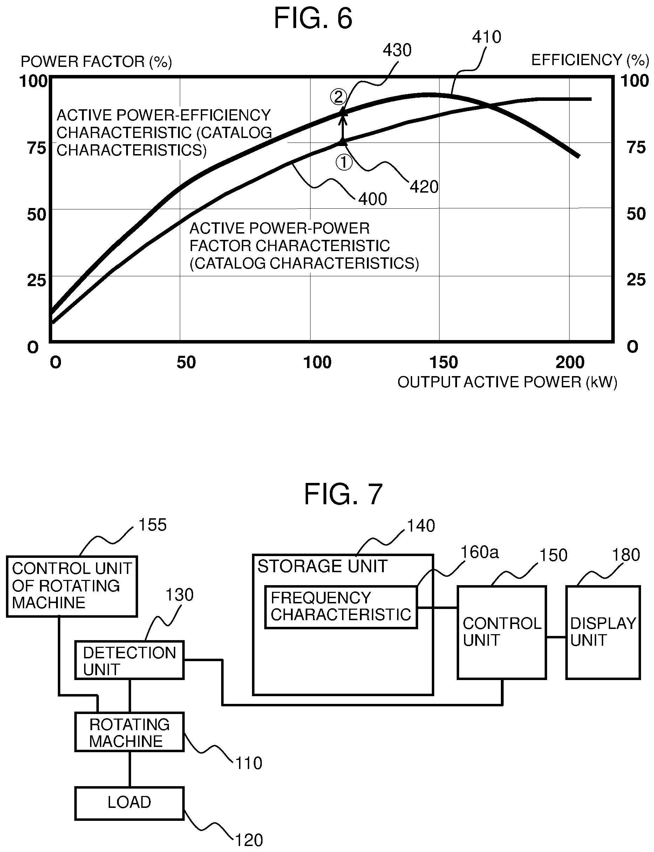

Fig. 6 is a diagram for describing, using a graph, a principle of a method in which the system for diagnosing the rotating machine 110 specifies other load loss (mechanical loss + floating loss) using a relationship between active power, power factor, and efficiency of the catalog characteristics, which are product load factors, and is a diagram supplementing processing of the flowchart of Fig. 3.

The horizontal axis of Fig. 6 indicates the active power (output), and the vertical axis indicates the power factor and efficiency. The horizontal axis may be the active power (output) or may be represented by a load factor with respect to a rated output of the rotating machine 110.

A curve 400 is a load factor-power factor characteristic curve obtained by drawing an approximate line from power factor information for the active power (output) (or load factor) of the product load characteristic 160 based on the product specifications provided by the manufacturer in advance. A plurality of points is plotted from the load factor and power factor of the product load characteristic 160, and is connected by a curve so as to pass through each of the plotted points. That is, the curve is a curve drawn so as to connect or pass through the points plotted from the information of the product load characteristic 160 provided by the manufacturer rather than plotted points specified using the measured value.

A curve 410 is a load factor-efficiency characteristic curve obtained by drawing an approximate line from efficiency information for the active power (output) (or load factor) of the product load characteristic 160 based on the product specifications provided by the manufacturer in advance. While plotting of points used to draw the curve 410 is similar to that of the curve 400, points plotted using efficiency are different.

The active power (input) and power factor are calculated from the sensed current and voltage information, and plotted on the load factor-power factor characteristic curve 400. From the points plotted on the curve 400, since the output active power is the same, a point is plotted as a point 420 to treat the power factor of the specified curve 400 as efficiency. At this point in time, the active power (input) and the active power (output) are regarded as equivalent and plotted.

Next, the calculated power factor is assumed to be equivalent to the power factor of the product load characteristic 160, and is plotted as a point 430 together with the load factor-efficiency characteristic curve 410. That is, a perpendicular line is drawn as indicated by an arrow in the figure from a point plotted on the power factor of the curve 400 toward the efficiency of the curve 410, and a point intersecting with the curve 410 is plotted.

Since the efficiency may be specified from the point 430, the active power (output) is derived from the active power (input) and the efficiency by the above-mentioned calculation. When the active power (output) and efficiency can be specified, the load loss (copper loss + iron loss + mechanical loss + floating loss) may be obtained.

In the load loss (copper loss + iron loss + mechanical loss + floating loss), the copper loss is specified in advance in the product specifications provided by the manufacturer, and may be specified since the copper loss has a characteristic proportional to the square of the load factor.

Copper loss = (current [A])$^2$ × copper loss at rated time [kW]                          [Formula 3]

That is, load loss (iron loss + mechanical loss + floating loss) obtained by subtracting the copper loss from the load loss (copper loss + iron loss + mechanical loss + floating loss) may be calculated from the following formula.

[Formula 4]

$$\text{Efficiency [\%]} = \frac{\text{Active power (output) [kW]}}{\text{Active power (input) [kW]}} \times 100$$

$$= \frac{\text{Active power (output) [kW]}}{\text{Active power (output) [kW] + load loss [kW]}} \times 100$$

$$= \frac{\text{Active power (output) [kW]}}{\text{Active power (output) [kW] + (copper loss + iron loss + mechanical loss + floating loss) [kW]}} \times 100$$

[Formula 5]

$$\therefore \text{Load loss [kW] = (copper loss + iron loss + mechanical loss + floating loss) [kW]}$$

$$= \text{Active power (output) [kW]} - \frac{\text{Efficiency [\%]} \times \text{Active power (output) [kW]}}{\text{Efficiency [\%]} \div 100}$$

[Formula 6]

$$\therefore \text{Load loss excluding copper loss [kW]}$$

$$= \text{(Iron loss + mechanical loss + floating loss) [kW]}$$

$$= \text{Load loss [kW]} - \text{copper loss [kW]}$$

Further, when the iron loss is specified in the product specifications provided by the manufacturer in advance, other load loss (mechanical loss + floating loss) may be calculated by excluding the iron loss without change. When the iron loss is not specified in the product specifications provided by the manufacturer in advance, the active power (input) when power is supplied without connecting the load to the rotating machine 110 is measured, and a measurement result is treated as equivalent to the iron loss, so that other load loss (mechanical loss + floating loss) may be obtained using the following formula by subtracting the equivalent iron loss from the load loss (iron loss + mechanical loss + floating loss) excluding the copper loss.

```
        [Formula 7]

        Other load loss [kW]

    = (Mechanical loss + floating loss) [kW]

    = Load loss [kW] – copper loss [kW] – iron loss [kW]

    = Load loss excluding copper loss [kW] – iron loss [kW]
```

Second Example

Fig. 7 is a block diagram of an example in which frequency control of the rotating machine is performed by the control unit 155 of the rotating machine, and is an application version of Fig. 2.

The load 120 driven by the rotating machine 110 is illustrated on the rotating machine 110 such as the induction motor 40. The control unit 155 of the rotating machine for controlling the rotation speed of the rotating machine 110 by frequency control is connected. Further, the detection unit 130 that detects a state of the rotating machine 110 for driving the load 120 is included, and the control unit 150 is provided to cause the storage unit 140 to store the state of the rotating machine 110 detected by the detection unit 130 as a frequency characteristic 160a. The control unit 150 performs predetermined processing from information of the frequency characteristic 160a stored in the storage unit 140, and displays a calculation result on the display unit 180. A difference from Fig. 2 is that information stored in the storage unit 140 has the frequency characteristic 160a.

In this figure, the control unit 155 of the rotating machine and the detection unit 130 are separately illustrated. However, the control unit 155 of the rotating machine may have a function of the detection unit 130.

In addition, as described in Fig. 2, a frequency characteristic detection method may be detected from voltage or voltage information.

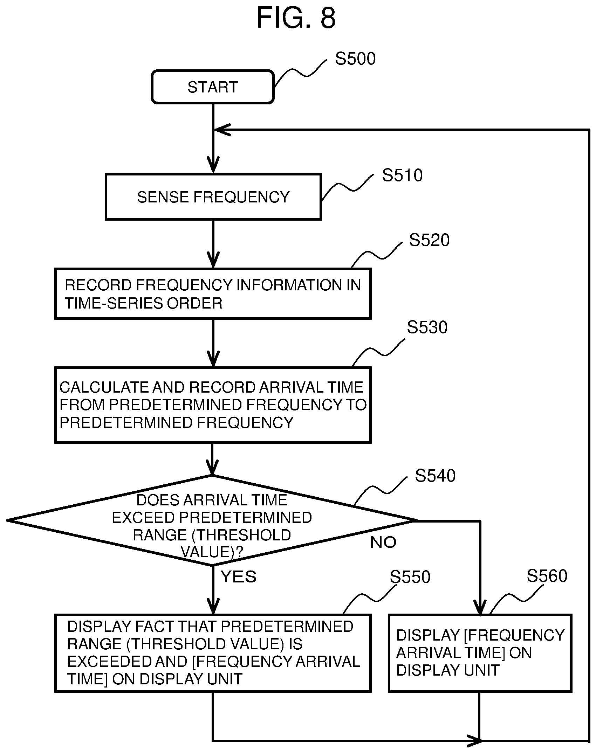

Fig. 8 illustrates a flowchart of processing of the system configuration of the block diagram of Fig. 7.

Processing of the system for diagnosing the rotating machine of this example starts from step S500, which is a START process. In step S510, a frequency obtained from the detection unit 130 is sensed. In step S520, frequency information is stored in the storage unit 140 as the frequency characteristic 160a. In step S530, a time for reaching a second predetermined frequency from a first predetermined frequency is calculated and stored in the storage unit 140 as the frequency characteristic 160a. Note that a plurality of predetermined frequencies may be present.

Step S540 is a process of determining whether or not the arrival time calculated in step S530 exceeds a predetermined range (threshold value). When the threshold value is exceeded, the fact that the predetermined range (threshold value) is exceeded and [frequency arrival time] is displayed on the display unit 180 in step S550, and then the process returns to frequency sensing in step S510.

When the predetermined range (threshold value) is not exceeded in step S540, [frequency arrival time] is displayed on the display unit 180, and then the process returns to frequency sensing in step S510.

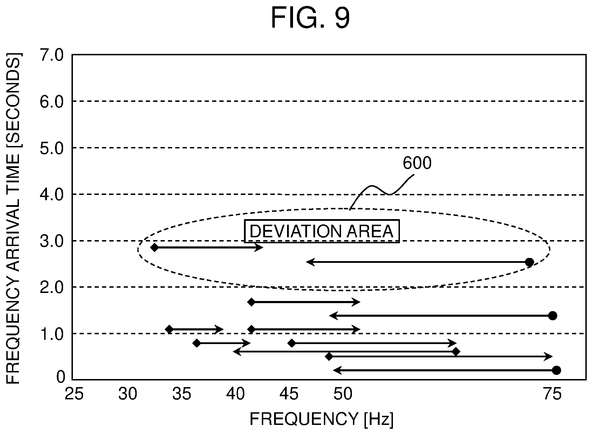

Fig. 9 is a diagram for describing a scheme of performing diagnosis including the rotating machine 110 and the load 120 when the rotating machine 110 described in the block diagram of Fig. 7 and the flowchart of Fig. 8 is controlled by the inverter, etc. (the control unit 155 of the rotating machine 110) using a user interface.

The horizontal axis of Fig. 9 indicates frequency, and the vertical axis indicates frequency arrival time. For example, a time required for a rotation frequency of the rotating machine 110 to reach 50 Hz starting from 35 Hz is measured and plotted in this figure. In the running state of the rotating machine 110, when there are several phases of the behavior of reaching 50 Hz starting from 35 Hz, the arrival time is plotted in a similar manner. Similarly, the arrival time under the same condition at the rotation frequency at which the rotating machine 110 actually runs, such as changing from 20 Hz to 45 Hz, is measured and plotted.

In such a case, when the mechanical loss of the rotating machine 110 and the load 120 increases over time, the arrival time under the same condition tends to increase.

In this case, it is possible to perform diagnosis including the rotating machine 110 and the load 120 by providing a deviation area indicated by 600 by utilizing this tendency. In this example, when various frequency conversions are performed, the case of being within 2.0 seconds is a normal operation, and the case of exceeding 2.0 is regarded as an abnormal state and belongs to the deviation area. That is, when the frequency is changed from 33 Hz to 43 Hz and when the frequency is changed from 75 Hz to 46 Hz, it takes time for frequency conversion of 2.0 seconds or more, and thus it is indicated that some abnormal state is obtained.

Third Example

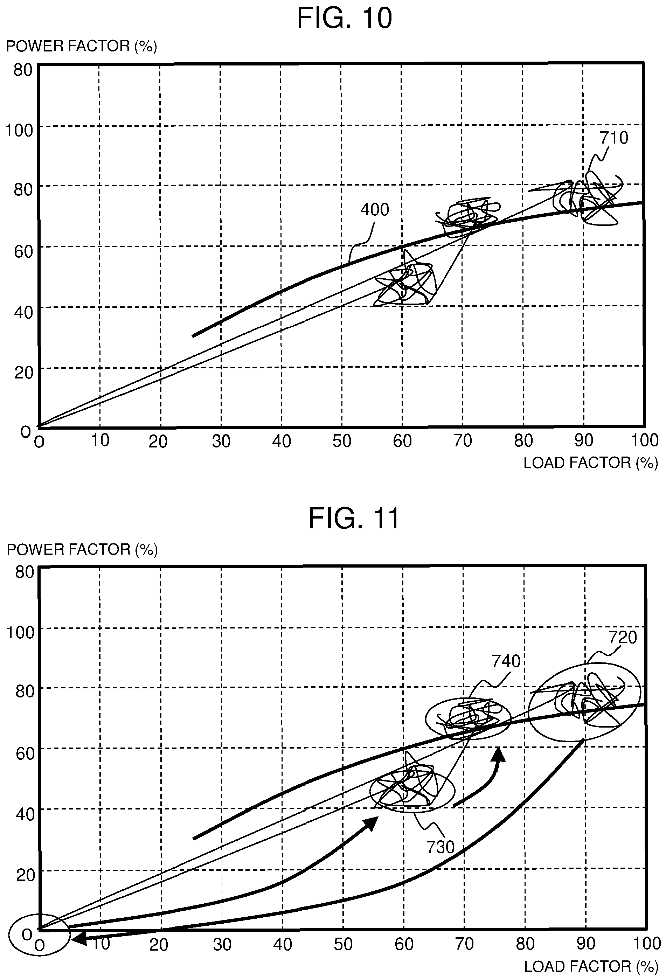

Next, the case of performing diagnosis including the rotating machine 110 and the load 120 is described in a third example using Fig. 10 and Fig. 11, which are graphs of the relationship between the active power and the power factor of the catalog specifications, which are product load factors.

The horizontal axis of Fig. 10 and Fig. 11 indicates the load factor with respect to the rated output of the rotating machine 110, and the vertical axis indicates the power factor and efficiency. The horizontal axis may indicate the load factor with respect to the rated output of the rotating machine 110, or may indicate the active power (output).

As in Fig. 6, a curve 400 is a load factor-power factor characteristic curve obtained by drawing an approximate line from power factor information for the load factor (or the active power (output)) of the product load characteristic 160 based on the product specifications provided by the manufacturer in advance. A plurality of points is plotted from the load factor and power factor of the product load characteristic 160, and is connected by a curve so as to pass through each of the plotted points.

That is, the curve 400 is a curve drawn so as to connect or pass through the points plotted from the information of the product load characteristic 160 provided by the manufacturer rather than plotted points specified using the measured value.

Meanwhile, an obtained state 710 illustrated in Fig. 10 is a load factor-power factor characteristic plotted line plotted by calculating the active power (input) and the power factor from the sensed current and voltage information on the graph on which the load factor-power factor characteristic curve 400 is drawn. The obtained state 710 is plotted assuming that the active power (input) and the active power (output) are equivalent at this point in time.

Fig. 11 illustrates movement of the plotted points. An area 720 represents a normal operation state, an area 730 represents a state in which a degree of vacuum is increased after replacing the pump portion, which is the load 120, and an area 740 represents a normal operation state in which the degree of vacuum is ensured after replacing the pump portion, which is the load 120.

From a load factor-power factor characteristic plotted line 710 of Fig. 11, there are two findings obtained from a diagnostic point of view. One is that the load factor during normal operation may be reduced by replacing the pump portion, which can be seen from a shift from the area 720 to the area 740.

A reason therefor is that the mechanical loss, etc is reduced and the load factor is lowered by replacing the pump portion.

Paradoxically, the area 740 is considered to be an initial normal operation state, and the area shifts to the area 720 as the mechanical loss, etc. of the rotating machine 110, the pump portion, etc. increases. Therefore, by managing the load factor-power factor characteristic plotted line 710, it is possible to diagnose the rotating machine 110, the pump unit, etc.

A running status may be displayed as illustrated in Fig. 11 before and after the pump is replaced, and based on the displayed information, it is possible to specify a state before the user replaces the pump as the area 720, a transition state as the area 730, and a stable operating state in which a degree of vacuum is highly refreshed as the area 740. The areas 720 to 740 may be set by the user while checking the obtained state 710 displayed on the display unit.

Further, for example, since there is a region close to a straight line from a point where the power factor and the load factor are zero to a region which seems to be the area 730, it is considered that the pump is in a starting state. Thereafter, since there is a region where the load factor and the power factor change, such as the area 730, the area may be specified as a linear region and a non-linear region, and thus it is possible to automatically set a region other than the linear region as the area 730.

Not only before and after replacement, but also when the operating time exceeds a certain time, the area 720, etc. may be reset, and by monitoring the pump using the reset information, it is possible to diagnose the state of the pump in consideration of a more actual running state.

In the conventional threshold value setting, a usual state is set to the normal operation of the area 740. However, in this case, since the measured value after the replacement of the pump is present in the area 720, it is determined that there is a sign or an indication of failure immediately after the replacement. In this way, the diagnostic system continues to give an alert, and an indication that needs to be checked may be missed. The diagnostic system of this example may specify a sign or an indication of abnormality from the actual running state.

Another feature obtained from Fig. 11 is the presence of the area 730, which is a behavior in a transition state in which the degree of vacuum is increased after the pump portion is replaced.

In order to confirm that the degree of vacuum in the pump portion including the inside of a pipe is ensured, determination has been made by measurement using a vacuum pressure sensor as a conventional technology.

However, the behavior of the load factor-power factor characteristic plotted line 710 indicates that, during plotting around the area 730 below the load factor-power factor characteristic curve 400, specifically, the area 730 having a lower load factor and a lower power factor than those of the area 740, the degree of vacuum cannot be ensured. After replacing a part of the pump, air enters a part of a flow path and the degree of vacuum drops. However, in this case, since air pulls up the flow path in a state where the density is low when compared to a fluid, the load factor becomes low as the torque of the pump decreases. In addition, since the load factor decreases, the power factor decreases.

That is, when observing the characteristics of the motor alone, the case where a position, at which the load factor and the power factor after the replacement of the part of the pump are plotted, is away from the curve 400 is not determined to be normal. However, the area 730 in the transition state containing air may be specified as being normal in the transition state. In this way, when only the threshold value is observed by this time, the state may be specified as abnormal. Even in a state determined to be a sign or an indication of abnormality, when the operation of the pump is considered, the area 730, which is in a transition state up to the normal area 740 after replacing the part, may be specified as normal. When the pump state belongs to the area 730 in the transition state, setting may be performed not to give an alert.

In this way, by drawing the load factor and characteristics of the pump, etc. as a graph, for example, it is possible to specify a state in which a target device or a target system, such as a vacuum pump, is not normal, which may be considered as an alternative to a confirmation method using a conventional vacuum degree sensor. The state of the pump may be specified without providing a separate vacuum degree sensor. Fourth Example

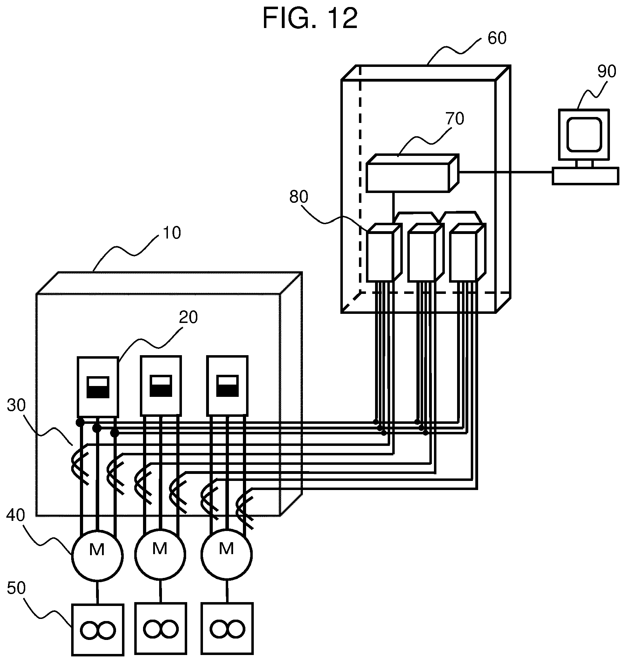

Fig. 12 is an example of a system for diagnosing a plurality of induction motors 40 by applying the diagnosis system of Fig. 1.

In general, a plurality of molded case circuit breakers 20 is lined up on the distribution board 10 and connected to each induction motor 40 and load 50 in many cases. In this case, similarly to Fig. 1, the current transformer (CT) 30 is mounted on each of the molded case circuit breakers 20 to detect the current of the induction motor 40. Further, a plurality of measuring devices 80 measures the current detected by the current transformer (CT) 30 (hereinafter, also simply referred to as CT 30), and collects the measured current by the data collecting device 70. This system has the central processing unit 90 that controls these devices. The measuring device 80 may measure not only the current detected by the CT 30 but also other information such as a voltage and a frequency of the voltage.

The data collecting device 70 collects data of various electric quantities measured by the plurality of measuring devices 80. The central processing unit 90 has a display unit that communicates with the data collecting device 70 and displays data of various electric quantities, or displays an abnormality when it is determined that a characteristic different from the usual one described later is determined.

This figure illustrates an example in which the plurality of measuring devices 80 is connected to one data collecting device 70 and the data collecting device 70 collects data of the plurality of measuring devices 80 at once. However, it is conceivable that one measuring device 80 detects currents of the plurality of induction motors 40.

Further, it is possible to adopt a configuration in which a plurality of data collecting devices 70 is connected to the plurality of measuring devices 80, collects data, and is connected to the central processing unit 90. That is, it is possible to monitor the plurality of induction motors 40.

According to the embodiment, maintenance diagnosis of the induction motor may be performed based on information such as the current supplying power to the induction motor, and information of a plurality of induction motors may be generally collected together by a switch board or a distribution board, which is effective in facilitating systematization.

**REFERENCE SIGNS LIST**

| 10 | Distribution board |
| 20 | Molded case circuit breaker |
| 30 | Current transformer (CT) |
| 40 | Induction motor |
| 50 | Load |
| 70 | Data collecting device |
| 80 | Measuring device |
| 90 | Central processing unit |
| 110 | Rotating machine |

**Claims**

1. A rotating machine diagnosis system, comprising:

 a rotating machine (110) having a load (120) connected thereto;
 a detection unit (130) configured to detect a running load characteristic (170) when the rotating machine (110) is running;
 a storage unit (140); and
 a control unit (150), wherein:

 a product load characteristic (160) based on product specifications provided by a manufacturer of the rotating machine (110) is stored in the storage unit (140) beforehand; and
 the control unit (150) is configured to cause the storage unit (140) to store the running load characteristic (170) detected by the detection unit (130),
 to specify load loss other than copper loss using the product load characteristic (160) and the running load characteristic (170), and
 to cause a display unit (180) to display information based on a fact that the running load characteristic (170) is a characteristic different from usual when load loss other than the copper loss exceeds a predetermined range.

2. The rotating machine diagnosis system according to claim 1, wherein load loss other than the copper loss includes any one or more of mechanical loss, floating loss, and iron loss.

3. The rotating machine diagnosis system according to claim 1, wherein the different characteristic is a state of the rotating machine (110) specified based on specified load loss other than the copper loss.

4. The rotating machine diagnosis system according to claim 1, wherein the predetermined range is specified using load loss other than the copper loss specified in a past.

5. The rotating machine diagnosis system according to claim 1, wherein the predetermined range is set to a value of load loss other than the copper loss in a future estimated or specified based on a time-series change of load loss other than the copper loss specified in a past.

6. The rotating machine diagnosis system according to claim 2, wherein:

 the control unit is configured to specify iron loss of the rotating machine; and
 load loss other than the copper loss includes any one or more of mechanical loss or floating loss specified by excluding the specified iron loss.

7. The rotating machine diagnosis system according to claim 1, wherein

 the control unit (150) is configured to
 calculate a running power factor indicating a power factor of a running state from a sensed current and voltage information,
 to treat the calculated running power factor as a power factor of a power factor characteristic (400) with respect to active power based on the product load characteristic (160), to specify active power corresponding to the power factor of the power factor characteristic,
 to treat the specified corresponding active power as active power of an efficiency characteristic (410) with respect to active power based on the product load characteristic (160), to specify efficiency of the running state,
 to specify an output of the running state using the specified efficiency of the running state and the corresponding active power,
 to obtain load loss based on the specified efficiency and the specified output,
 to subtract copper loss from the obtained load loss, and
 to specify the running state as a state different from usual when load loss other than the copper loss is out of a predetermined range.

8. The rotating machine diagnosis system according to claim 7, wherein the control unit (150) is configured to specify a state of the rotating machine using a state of specified load loss other than the copper loss.

9. The rotating machine diagnosis system according to claim 7, wherein:

   load loss other than the copper loss includes friction loss of the rotating machine (110); and
   the control unit (150) is configured to specify that the rotating machine (110) is run in a state different from usual based on a change in the friction loss.

10. The rotating machine diagnosis system according to claim 7, wherein:

    the control unit (150) is configured to specify iron loss of the rotating machine (110); and
    load loss other than the copper loss includes any one or more of mechanical loss or floating loss specified by excluding the specified iron loss.

11. The rotating machine diagnosis system according to claim 1, further comprising:

    a control unit of rotating machine (155) for controlling the rotating machine (110) being connected to the rotating machine (110);
    wherein
    when the control unit of rotating machine (155) is configured to perform a control operation to change the rotating machine (110) from a first state to a second state,
    the control unit (150) is configured to specify a past change time which is a time required to change from the first state to the second state by detecting the running load characteristic by the detection unit (130) in advance, and causes the storage unit (140) to store the specified past change time; and
    when a time required for the rotating machine (110) to change from the first state to the second state, which is different from the past change time, is out of a predetermined range based on the past change time, the control unit (150) is configured to specify that the rotating machine (110) is running in a state different from usual.

**Patentansprüche**

1. Diagnosesystem für eine rotierende Maschine, das Folgendes umfasst:

   eine rotierende Maschine (110), die eine damit verbundene Last (120) aufweist;
   eine Detektionseinheit (130), die konfiguriert ist, dann, wenn die rotierende Maschine (110) läuft, eine Lauflastcharakteristik (170) zu detektieren;
   eine Speichereinheit (140); und
   eine Steuereinheit (150), wobei
   eine Produktlastcharakteristik (160) basierend auf Produktspezifikationen, die durch einen Hersteller der rotierenden Maschine (110) bereitgestellt werden, vorher in der Speichereinheit (140) gespeichert wird; und
   die Steuereinheit (150) konfiguriert ist, die Speichereinheit (140) zu veranlassen, die Lauflastcharakteristik (170), die durch die Detektionseinheit (130) detektiert worden ist, zu speichern,
   um anderen Lastverlust als Kupferverlust unter Verwendung der Produktlastcharakteristik (160) und der Lauflastcharakteristik (170) zu spezifizieren, und
   eine Anzeigeeinheit (180) zu veranlassen, Informationen basierend auf der Tatsache anzuzeigen, dass die Lauflastcharakteristik (170) eine Charakteristik ist, die sich von der üblichen unterscheidet, wenn ein anderer Lastverlust als Kupferverlust einen vorgegebenen Bereich überschreitet.

2. Diagnosesystem für eine rotierende Maschine nach Anspruch 1, wobei der andere Lastverlust als der Kupferverlust mechanischen Verlust, Schwebeverlust und/oder Eisenverlust enthält.

3. Diagnosesystem für eine rotierende Maschine nach Anspruch 1, wobei die andere Charakteristik ein Zustand der rotierenden Maschine (110) ist, der basierend auf einem anderen spezifizierten Lastverlust als dem Kupferverlust spezifiziert wird.

4. Diagnosesystem für eine rotierende Maschine nach Anspruch 1, wobei der vorgegebene Bereich unter Verwendung eines anderen Lastverlusts als dem Kupferverlust, der in der Vergangenheit spezifiziert worden ist, spezifiziert wird.

5. Diagnosesystem für eine rotierende Maschine nach Anspruch 1, wobei der vorgegebene Bereich auf einen Wert eines anderen Lastverlusts als dem Kupferverlust in der Zukunft eingestellt wird, der basierend auf einer Zeitreihenänderung des anderen Lastverlusts als dem Kupferverlust, der in der Vergangenheit spezifiziert worden ist, geschätzt oder spezifiziert wird.

6. Diagnosesystem für eine rotierende Maschine nach Anspruch 2, wobei:

die Steuereinheit konfiguriert ist, den Eisenverlust der rotierenden Maschine zu spezifizieren; und der andere Lastverlust als der Kupferverlust mechanischen Verlust und/oder Schwebeverlust, die durch Ausschließen des spezifizierten Eisenverlusts spezifiziert werden, enthält.

7. Diagnosesystem für eine rotierende Maschine nach Anspruch 1, wobei:
die Steuereinheit (150) konfiguriert ist:

einen Laufleistungsfaktor, der einen Leistungsfaktor eines Laufzustands anzeigt, aus erfassten Strom- und Spannungsinformationen zu berechnen,
den berechneten Laufleistungsfaktor basierend auf der Produktlastcharakteristik (160) als einen Leistungsfaktor einer Leistungsfaktorcharakteristik (400) bezüglich der aktiven Leistung zu behandeln, um die aktive Leistung entsprechend dem Leistungsfaktor der Leistungsfaktorcharakteristik zu spezifizieren,
die spezifizierte entsprechende aktive Leistung basierend auf der Produktlastcharakteristik (160) als aktive Leistung einer Effizienzcharakteristik (410) bezüglich der aktiven Leistung zu behandeln, um die Effizienz des Laufzustands zu spezifizieren,
eine Ausgabe des Laufzustands unter Verwendung der spezifizierten Effizienz des Laufzustands und der entsprechenden aktiven Leistung zu spezifizieren,
den Lastverlust basierend auf der spezifizierten Effizienz und der spezifizierten Ausgabe zu erhalten,
den Kupferverlust von dem erhaltenen Lastverlust zu subtrahieren, und
den Laufzustand als einen anderen Zustand als üblich zu spezifizieren, wenn anderer Lastverlust als der Kupferverlust außerhalb eines vorgegebenen Bereichs liegt.

8. Diagnosesystem für eine rotierende Maschine nach Anspruch 7, wobei die Steuereinheit (150) konfiguriert ist, einen Zustand der rotierenden Maschine unter Verwendung eines Zustands des anderen spezifizierten Lastverlusts als dem Kupferverlust zu spezifizieren.

9. Diagnosesystem für eine rotierende Maschine nach Anspruch 7, wobei:

anderer Lastverlust als der Kupferverlust Reibungsverlust der rotierenden Maschine (110) enthält; und
die Steuereinheit (150) konfiguriert ist, basierend auf einer Änderung in dem Reibungsverlust zu spezifizieren, dass die rotierende Maschine (110) in einem anderen Zustand als üblich betrieben wird.

10. Diagnosesystem für eine rotierende Maschine nach Anspruch 7, wobei:

die Steuereinheit (150) konfiguriert ist, den Eisenverlust der rotierenden Maschine (110) zu spezifizieren; und
anderer Lastverlust als der Kupferverlust mechanischen Verlust und/oder Schwebeverlust, die durch Ausschließen des spezifizierten Eisenverlusts spezifiziert werden, enthält.

11. Diagnosesystem für eine rotierende Maschine nach Anspruch 1, das ferner Folgendes umfasst:

eine Steuereinheit (155) der rotierenden Maschine zum Steuern der rotierenden Maschine (110), die mit der rotierenden Maschine (110) verbunden ist;
wobei
dann, wenn die Steuereinheit (155) der rotierenden Maschine konfiguriert ist, einen Steuerbetrieb durchzuführen, um die rotierende Maschine (110) von einem ersten Zustand in einen zweiten Zustand zu ändern,
die Steuereinheit (150) konfiguriert ist, eine vergangene Änderungszeit, die einer Zeit entspricht, die erforderlich ist, um von dem ersten Zustand in den zweiten Zustand zu wechseln, durch Detektieren der Lauflastcharakteristik durch die Detektionseinheit (130) im Voraus zu spezifizieren, und die Speichereinheit (140) veranlasst, die spezifizierte vergangene Änderungszeit zu speichern; und
dann, wenn eine Zeit, die für die rotierende Maschine (110) erforderlich ist, um von dem ersten Zustand in den zweiten Zustand zu wechseln, und die sich von der vergangenen Änderungszeit unterscheidet, außerhalb eines vorgegebenen Bereichs basierend auf der vergangenen Änderungszeit liegt, die Steuereinheit (150) konfiguriert ist, zu spezifizieren, dass die rotierende Maschine (110) in einem anderen Zustand als üblich läuft.

**Revendications**

1. Système de diagnostic de machine rotative, comprenant :

   une machine rotative (110) ayant une charge (120) connectée à celle-ci ;
   une unité de détection (130) configurée pour détecter une caractéristique de charge de fonctionnement (170) quand la machine rotative (110) est en fonctionnement ;
   une unité de stockage (140) ; et
   une unité de commande (150), dans lequel :

   une caractéristique de charge de produit (160) sur la base de spécifications de produit fournies par un fabricant de la machine rotative (110) est stockée au préalable dans l'unité de stockage (140) ; et
   l'unité de commande (150) est configurée
   pour amener l'unité de stockage (140) à stocker la caractéristique de charge de fonctionnement (170) détectée par l'unité de détection (130),
   pour spécifier une perte de charge autre qu'une perte de cuivre à l'aide de la caractéristique de charge de produit (160) et de la caractéristique de charge de fonctionnement (170), et
   pour amener une unité d'affichage (180) à afficher des informations d'affichage sur la base d'un fait selon lequel la caractéristique de charge de fonctionnement (170) est une caractéristique différente de la caractéristique habituelle quand une perte de charge autre que la perte de cuivre dépasse une plage prédéterminée.

2. Système de diagnostic de machine rotative selon la revendication 1, dans lequel la perte de charge autre que la perte de cuivre inclut une ou plusieurs pertes quelconques parmi : une perte mécanique, une perte de flottement, et une perte de fer.

3. Système de diagnostic de machine rotative selon la revendication 1, dans lequel la caractéristique différente est un état de la machine rotative (110) spécifié sur la base d'une perte de charge spécifiée autre que la perte de cuivre.

4. Système de diagnostic de machine rotative selon la revendication 1, dans lequel la plage prédéterminée est spécifiée à l'aide d'une perte de charge autre que la perte de cuivre spécifiée dans un passé.

5. Système de diagnostic de machine rotative selon la revendication 1, dans lequel la plage prédéterminée est réglée à une valeur de perte de charge autre que la perte de cuivre dans un futur estimé ou spécifié sur la base d'un changement en série temporelle d'une perte de charge autre que la perte de cuivre spécifiée dans un passé.

6. Système de diagnostic de machine rotative selon la revendication 2, dans lequel :

   l'unité de commande est configurée pour spécifier une perte de fer de la machine rotative ; et
   une perte de charge autre que la perte de cuivre inclut une ou plusieurs pertes quelconques parmi : une perte mécanique ou une perte de flottement spécifiées à l'exclusion de la perte de fer spécifiée.

7. Système de diagnostic de machine rotative selon la revendication 1, dans lequel

   l'unité de commande (150) est configurée pour
   calculer un facteur de puissance de fonctionnement indiquant un facteur de puissance d'un état de fonctionnement à partir d'informations de courant et de tension détectés,
   pour traiter le facteur de puissance de fonctionnement calculée à titre de facteur de puissance d'une caractéristique de facteur de puissance (400) par rapport à une puissance active sur la base de la caractéristique de charge de produit (160), pour spécifier une puissance active correspondant au facteur de puissance de la caractéristique de facteur de puissance,
   pour traiter la puissance active correspondante spécifiée à titre de puissance active d'une caractéristique d'efficacité (410) par rapport à une puissance active sur la base de la caractéristique de charge de produit (160), pour spécifier une efficacité de l'état de fonctionnement,
   pour spécifier une sortie de l'état de fonctionnement à l'aide de l'efficacité spécifiée de l'état de fonctionnement et de la puissance active correspondante,
   pour obtenir une perte de charge sur la base de l'efficacité spécifiée et de la sortie spécifiée,
   pour soustraire une perte de cuivre de la perte de charge obtenue, et

pour spécifier l'état de fonctionnement à titre d'état différent de l'état habituel quand une perte de charge autre que la perte de cuivre est hors d'une plage prédéterminée.

8. Système de diagnostic de machine rotative selon la revendication 7, dans lequel l'unité de commande (150) est configurée pour spécifier un état de la machine rotative à l'aide d'un état de perte de charge spécifiée autre que la perte de cuivre.

9. Système de diagnostic de machine rotative selon la revendication 7, dans lequel :

   une perte de charge autre que la perte de cuivre inclut une perte de frottement de la machine rotative (110) ; et
   l'unité de commande (150) est configurée pour spécifier que la machine rotative (110) est en fonctionnement dans un état différent de l'état habituel sur la base d'un changement dans la perte de frottement.

10. Système de diagnostic de machine rotative selon la revendication 7, dans lequel :

   l'unité de commande (150) est configurée pour spécifier une perte de fer de la machine rotative (110) ; et
   une perte de charge autre que la perte cuivre inclut une ou plusieurs pertes quelconques parmi : une perte mécanique ou une perte de flottement spécifiées à l'exclusion de la perte de fer spécifiée.

11. Système de diagnostic de machine rotative selon la revendication 1, comprenant en outre :

   une unité de commande de machine rotative (155) destinée à commander la machine rotative (110), qui est connectée à la machine rotative (110) ;
   dans lequel
   quand l'unité de commande de machine rotative (155) est configurée pour effectuer une opération de commande pour faire passer la machine rotative (110) d'un premier état à un second état,
   l'unité de commande (150) est configurée pour spécifier un temps de changement passé qui est un temps requis pour passer du premier état au second état en détectant en avance la caractéristique de charge de fonctionnement via l'unité de détection (130), et amène l'unité de stockage (140) à stocker le temps de changement passé spécifié ; et
   quand un temps requis pour que la machine rotative (110) passe du premier état au second état, qui est différent du temps de changement passé, est hors d'une plage prédéterminée sur la base du temps de changement passé, l'unité de commande (150) est configurée pour spécifier que la machine rotative (110) est en fonctionnement dans un état différent de l'état habituel.

# FIG. 1

# FIG. 2

# FIG. 3

START — S210

PRODUCT LOAD CHARACTERISTIC (POWER FACTOR, EFFICIENCY, IRON LOSS, AND COPPER LOSS) — S215

SENSE CURRENT AND VOLTAGE — S220

CALCULATE ACTIVE POWER (INPUT), APPARENT POWER, AND POWER FACTOR USING PRODUCT LOAD CHARACTERISTIC (POWER FACTOR AND EFFICIENCY) — S230

CALCULATE EFFICIENCY OF PRODUCT LOAD CHARACTERISTIC CORRESPONDING TO POWER FACTOR OF PRODUCT LOAD CHARACTERISTIC FROM CALCULATED POWER FACTOR — S250

CALCULATE ACTIVE POWER (OUTPUT) USING PRODUCT LOAD CHARACTERISTIC (IRON LOSS AND COPPER LOSS) — S260

CALCULATE [OTHER LOAD LOSS (MECHANICAL LOSS + FLOATING LOSS)] FROM ACTIVE POWER (INPUT), ACTIVE POWER (OUTPUT), IRON LOSS, AND COPPER LOSS USING PRODUCT LOAD CHARACTERISTIC (IRON LOSS AND COPPER LOSS) — S280

DOES OTHER LOAD LOSS EXCEED PREDETERMINED RANGE (THRESHOLD VALUE)? — S290

NO

YES

DISPLAY FACT THAT PREDETERMINED RANGE (THRESHOLD VALUE) IS EXCEEDED OR [OTHER LOAD LOSS (MECHANICAL LOSS + FLOATING LOSS)] ON DISPLAY UNIT — S294

DISPLAY [OTHER LOAD LOSS (MECHANICAL LOSS + FLOATING LOSS)] ON DISPLAY UNIT — S295

# FIG. 4

MECHANICAL LOSS + FLOATING LOSS (kW)

# FIG. 5

MECHANICAL LOSS + FLOATING LOSS (kW)

## FIG. 6

## FIG. 7

# FIG. 8

START — S500

SENSE FREQUENCY — S510

RECORD FREQUENCY INFORMATION IN TIME-SERIES ORDER — S520

CALCULATE AND RECORD ARRIVAL TIME FROM PREDETERMINED FREQUENCY TO PREDETERMINED FREQUENCY — S530

DOES ARRIVAL TIME EXCEED PREDETERMINED RANGE (THRESHOLD VALUE)? — S540

NO

YES

DISPLAY FACT THAT PREDETERMINED RANGE (THRESHOLD VALUE) IS EXCEEDED AND [FREQUENCY ARRIVAL TIME] ON DISPLAY UNIT — S550

DISPLAY [FREQUENCY ARRIVAL TIME] ON DISPLAY UNIT — S560

# FIG. 9

# FIG. 10

# FIG. 11

FIG. 12

**EP 4 053 532 B1**

**Patent documents cited in the description**

- JP 2004124765 A

- US 2019003928 A1